Europäisches Patentamt

European Patent Office

Office européen des brevets

(11) Publication number: **0 311 574**
A2

## (12) EUROPEAN PATENT APPLICATION

(21) Application number: 88830379.9

(22) Date of filing: 20.09.88

(51) Int. Cl.⁴: **H 02 B 1/03**
H 05 K 7/14, H 02 B 1/20

(30) Priority: 06.10.87 IT 2216687

(43) Date of publication of application:
12.04.89 Bulletin 89/15

(84) Designated Contracting States:
BE CH DE ES FR GB LI NL SE

(71) Applicant: **Apostolo, Carlo**
**Via San Marcellino, 25**
**I-22050 Merate (Como) (IT)**

(72) Inventor: **Apostolo, Carlo**
**Via San Marcellino, 25**
**I-22050 Merate (Como) (IT)**

(74) Representative: **Cicogna, Franco**
**Ufficio Internazionale Brevetti Dott.Prof. Franco Cicogna**
**Via Visconti di Modrone, 14/A**
**I-20122 Milano (IT)**

(54) Withdrawing drawer modular composable electrical panel for controlling electrical motors.

(57) The present invention relates to a withdrawing drawer modular and composable electrical panel for controlling electrical motors which comprises a central body, essentially consisting of a metal box-like parallelepipedal block, machined with tight tollerances, of the order of 1/100 mm, and a plurality of electromecanical operating element, directly monted on the central body.

These operating elements comprise one or more of the following component members: a power output system, a fixed auxiliary circuit terminal block part, cross members for supporting the cables of an adjoining column or upright, a fixed part of an interexchangeable block for different drawers, fixed guides for the drawers and assembling abutments.

FIG. 1

EP 0 311 574 A2

Description

# WITHDRAWING DRAWER MODULAR AND COMPOSABLE ELECTRICAL PANEL FOR CONTROLLING ELECTRICAL MOTORS

## BACKGROUND OF THE INVENTION

The present invention relates to a withdrawing drawer electrical panel, of the modular and composable type, for controlling electrical motors.

As is known, there are presently commercially available withdrawing drawer electrical panels, for controlling electrical motors, or the so-called "Motor Control Center" (M.C.C.), which electrical panels have different levels of performance both of the mechanical and electrical type, depending on the different market requirements.

Among the most stringent specifications, there are included the Italian specifications, which require very high levels of short resistance and very stringent protection devices from the operation and safety standpoint.

## SUMMARY OF THE INVENTION

Accordingly, the task of the present invention is to provide a M.C.C. electrical panel, of the withdrawing drawer type, which is able of meeting the most stringent and severe requirements and which, in particular, is highly modular, flexible and safe.

Within the scope of the above mentioned task, a main object of the present invention is to provide a withdrawing-drawer electrical panel, of high performance both with respect to the bus-bar rate and with respect to the short resistances.

Another object of the present invention is to provide such an electrical panel which is able of housing a very high number of drawers for column or upright and, which, moreover, includes means for allowing the blank, sectioned and powered-up position.

Yet another object of the present invention is to provide such an electrical panel able of providing a complete segregation, with an inner minimum protection degree IP20 for the bus-bar zone and the output and auxiliary power zone, which comprises a plurality of mechanical and electrical interlocking blocks and, in particular, a mechanical block adapted to allow for a drawer to be introduced and/or withdrawn exclusively as the main or power contacts and the auxiliary contacts are in their open condition; a mechanical block adapted to prevent the door from closing both with non operated auxiliary contacts and with the operation of the main contacts in the locking position; a mechanical block adapted to allow for the door to be opened exclusively with an operation in the "sectioned" position; an electrical block adapted to prevent the main contact from being operated in an under-load condition, that is with the power contactor in its closed condition; and a mechanical block adapted to restrain by a lock, for safety reasons, the operation to the "sectioned" position.

Yet another object of the present invention is to provide such a withdrawing-drawer electrical panel able of meeting the national and international safety standards and which can be made starting from only two types of sheet metal and is susceptible to be easily assembled and serviced.

According to one aspect of the present invention, the above mentioned task and objects, as well as yet other objects, which will become more apparent hereinafter, are achieved by a modular and composable withdrawing drawer electrical panel for controlling electrical motors having the features stated in the characterizing part of the first claim.

Further characteristics of the electrical panel according to the present invention are defined in the depending claims.

## BRIEF DESCRIPTION OF THE DRAWINGS

Further features and advantages of the withdrawing drawer electrical panel according to the invention, will become more apparent hereinafter from the following detailed description of a preferred, though not exclusive, embodiment of said electrical panel, which is illustrated, by way of an indicative but not limitative example, in the accompanying drawings, where:

Figure 1 is a perspective view of the modular central body of the electrical panel according to the invention, thereto several electromechanical elements have been applied for making determined arrangements of the subject electrical panel;

Figure 2 is another perspective view of the same central body illustrated in Figure 1, showing, in particular: the fixed portion of the interexchangeability block for different drawers, the drawer fixed guides as well as abutment elements for applying other electromechanical component members for making the electrical panel;

Figures 3 shows another perspective view of the same central body of Figure 1, and illustrates, in a more detailed way: cross-members for supporting cables of an adjoining column or upright (not shown), the rear closure panel, the outer upright and doors, as well as the electrical terminated portions and raising tools, which mentioned elements represent main component members for making the subject electrical panel;

Figure 4 is a perspective view illustrating a single modular base drawer, for application with fuse protection up to 400A, and in which there is specifically shown the interexchangeability block;

Figure 5 is a further perspective view of the drawer shown in the preceding Figure, also provided with an interexchangeability block, and with automatic breaker protection up to 400A; and

Figure 6 is a schematic view showing different module drawers which can be made starting from the base drawer by simply adding members for supporting electrical appliances, such as a so-called "book system" affording the possibility of performing the wiring by means of pre-cut and pre-electrically terminated wires and for supporting additional instruments.

## DESCRIPTION OF THE PREFERRED EMBODIMENTS

With reference to the above mentioned Figures of the accompanying drawings, the electrical panel according to the invention comprises a sheet metal central body, of substantially box-like parallelepipedal shape, indicated at the reference letter C.

This central body C represents the main element of the subject M.C.C. electrical panel, which differentiates it from any other types of presently commercially available electrical panels: in fact, this central body C affords the possibility of reducing to a single component piece all of the size references, owing to the precision assured by a particularly designed machining of the central body C, by means of a numerically controlled machine, said precision being of the order of 1/100 mm.

In this connection, it should be pointed out that the presently available electrical panels are generally formed by two or more elements, to be mutually assembled by several known methods, which, on the other hand, require the use of templates for assuring the desired assembling precision which, however, is much less than that provided by a NC machine.

Thus, owing to the adoption of the above mentioned very narrow tolerances, as provided by a NC machine, the central body constitutes the base element for making the electrical panel according to the invention.

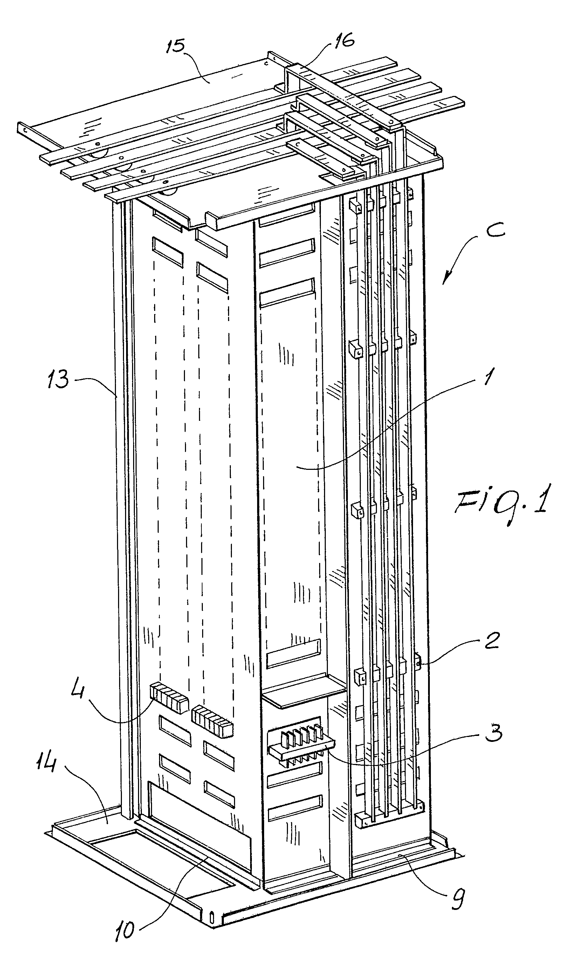

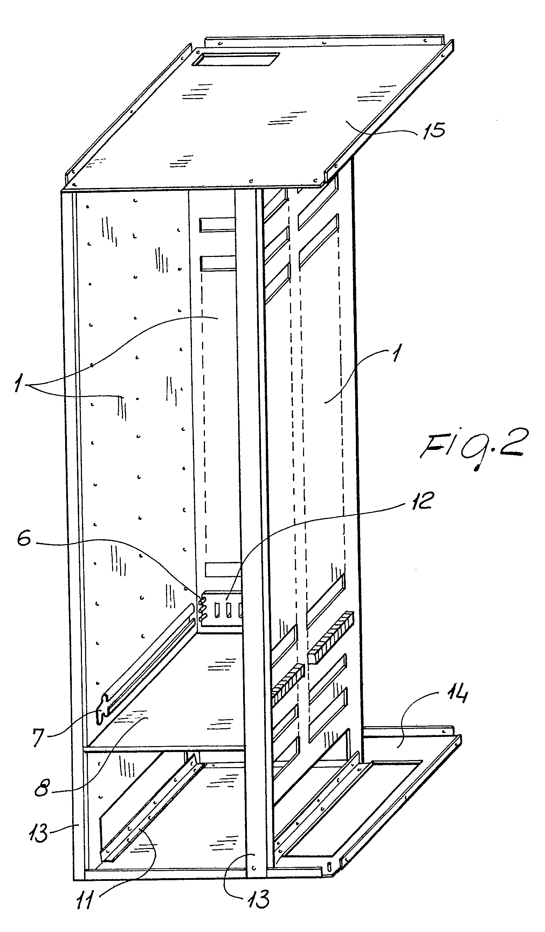

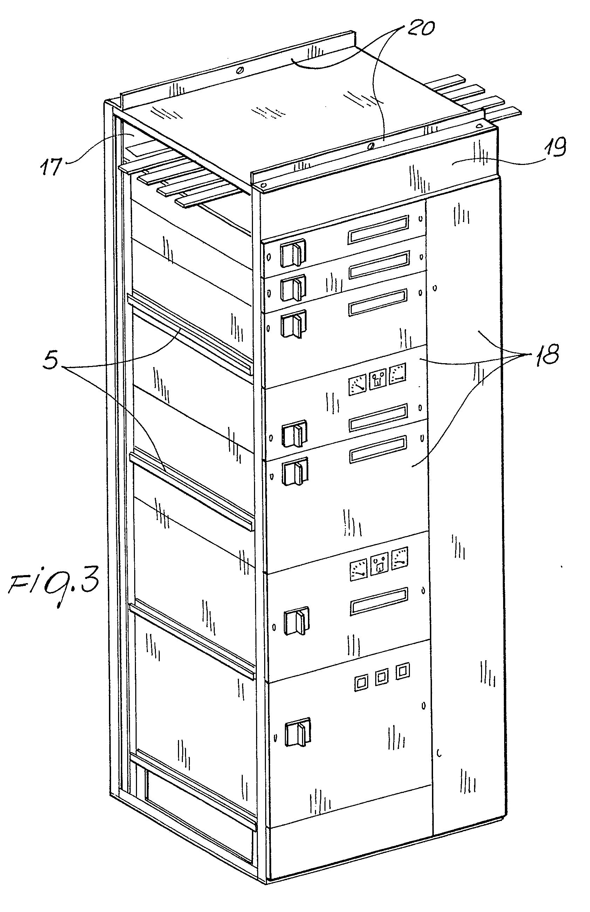

All of the other component elements, which operatively intervene into the construction of the subject electrical panel can be directly mounted on the central body, and this component elements substantially comprise: the vertical supply bus-bar system with related bus-bar holders, which system has been overally indicated at the reference number 2 in Figure 1, the power output system, indicated at the reference number 3, the fixed portion of the auxiliary circuits of the terminal blocks, which fixed portion has been indicated in Figure 1 by the reference number 4, the cross-members for supporting the cables of the adjacent columns, indicated at 5 in Figure 3; the fixed portion of the interexchangeability block provided for different drawers, which fixed portion has been indicated in Figure 2 by the reference number 6, the drawer fixed guides, indicated by the reference number 7 in Figure 2; all of the abutment elements for applying shelves between drawer and drawer, as indicated in Figure 2 at the reference number 8, of details for affixing elements at the base and intermediate electrical terminal portion, as indicated in Figure 1 by the references numbers 9 and 10 and in Figure 2 by the reference number 11, for protectively insulating the bus-bar zones with a IP20 degree, as indicated in Figure 2 by the number 12 and, finally, abutment elements for applying vertical front uprights, indicated at 13 in Figure 1, with all of the references for the drawer insertion blocks.

Owing to the provision of the above dis closed central body C, the electrical panel according to the invention can be assembled in a very easy and quick way: in fact, on the base construction, consisting, as shown in Figures 1 and 2, of the central body 1, the base 14, intermediate electrical terminal portion 15 and front uprights 13, there are mounted, according to the desired arrangement to be made, all of the already mentioned component elements.

In this connection, is should be apparent that the construction of the central body C, which is free at each side, affords the possibility of using suitable automatic assembling device such as riveting devices and the like, thereby reducing very greatly the assembling time.

The bus-bar system may be completed for the application of omnibus bus-bar, as indicated at 16 in Figure 1.

More specifically, after having completed the individual columns, they are further provided with the rear panels 17 (Figure 3), the outer uprights and doors (see the reference number 18 in Figure 3).

After having assembled the columns in the number provided for transportation, for example up to a maximum of 6, the omnibus bus-bar are assembled and suitably located and, finally, there are assembled the electrically terminated portion, as indicated at 19 in Figure 3, jointly with the raising tools 20.

According to the invention, the omnibus bus-bar system has been specifically designed for affording the possibility, by a single type of bus-bars, (20x10), of making omnibus conductor bars of 400, 800, 1200 mm$^2$.

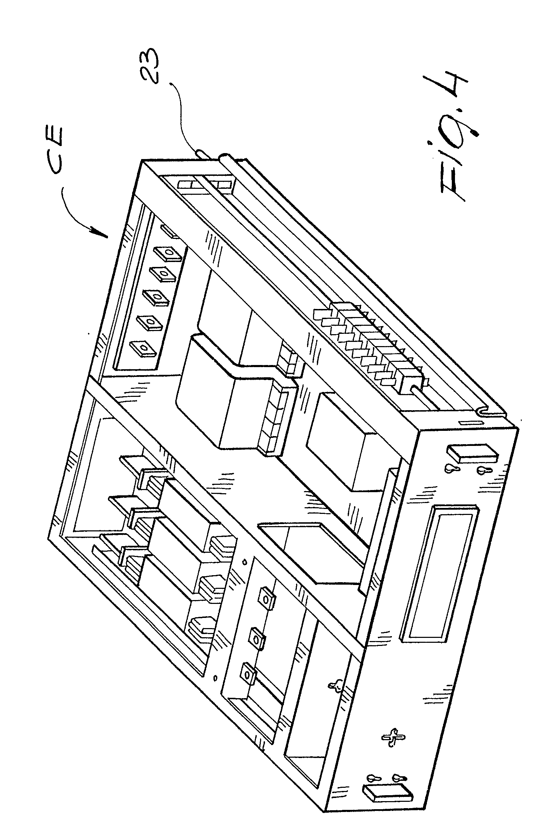

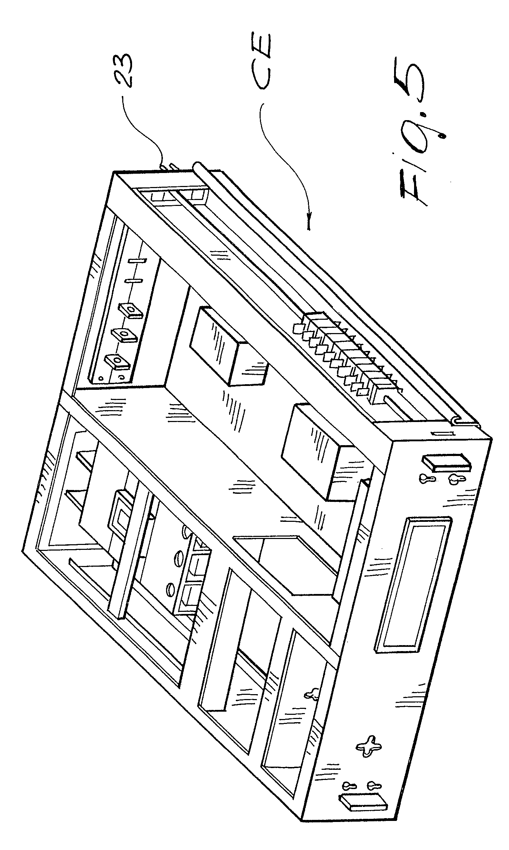

According to a further aspect of the invention, the electrical panel provides for the use of a specific withdrawing drawer, of modular type, which has been represented by perspective views in Figures 4 and 5 and has been indicated at the reference letters CE.

In the connection it should be pointed out that all of the presently available M.C.C. electrical panels, are provided with different drawers for each size, that is a different number of modules which, obviously, is a drawback.

In the electrical panel according to the invention, on the contrary, there is provided a single base drawer CE, for application with fuse protection up to 400A, as shown in Figure 4, or with an automatic breaker up to 400A, as shown in Figure 5.

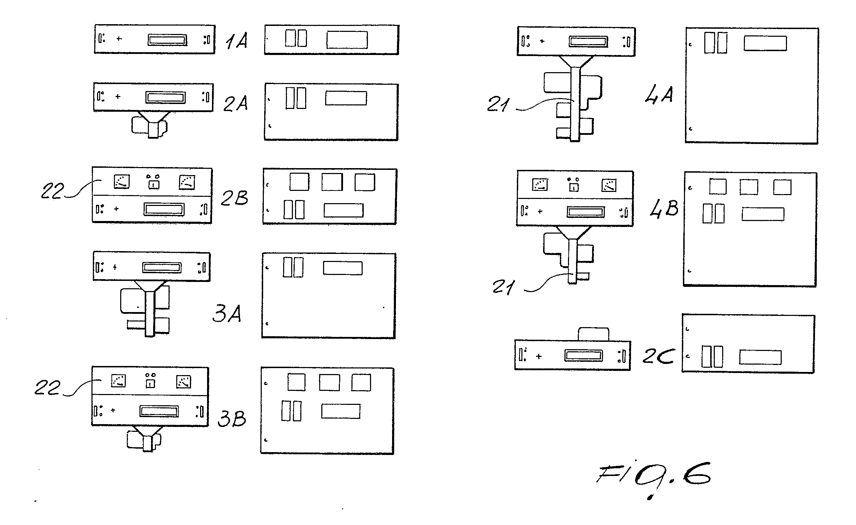

Figure 6, finally, shows different modular drawers, which can be made starting from the base drawer by simply adding supporting elements for supporting electrical appliances, and in particular a so-called book system, indicated at the reference number 21, which affords the possibility of carrying out the wiring operations by using precut and electrically preterminated wires, and support elements for additional instruments, as indicated, by way of example, at 22,

Obviously, the several types of doors can be varied depending on the type and module of drawer.

In this connection it should be apparent that the system, as it has been designed, would be able of receiving smaller-module drawer in broader recesses or the replacement with a type of drawer by another drawer of like module but operatively different; in order to prevent these drawbacks, there has been provided the interexchangeability block consiting of small pins 23, shown in Figures 4 and 5, able of engaging in corresponding seats, defined on suitable portions of the central body.

From the above disclosure it should be apparent that the invention fully achieves the intended task and objects.

While the electrical panel of the withdrawing drawer type, according to the invention,has been specifically illustrated with reference to a preferred embodiment thereof, it should be pointed out that the disclosed embodiments are susceptible to several modifications and variations all of which will come within the spirit and scope of the invention.

In particular, the used material, though the best results have been obtained by using for constructing the electrical panel only two types of sheet metal, in particular black sheet metal 20/10 to be painted and pre-galvanized sheet metal 15/10, as well as the contigent size and shapes, can be any according to requirements.

## Claims

1. A withdrawing-drawer modular and composable electrical panel, for controlling electrical motors, characterized in that said electrical panel comprises a central body, essentially consisting of a metal box-like parallelepipedal block, machined with narrow tolerances, of the order of 1/100 mm, obtained by using a NC machine, and a plurality of electromechanical operating elements which are directly mounted on said central body, said electromechanical operating elements comprising one or more of the following component members: a vertical bus-bar power supply system with related bus-bar holders, a power output system, a fixed portion of the auxiliary circuit terminal block, cross-members for supporting the cables of an adjoining column, a fixed portion of an interexchangeability block for different drawers, fixed guides for said drawers and assembling abutment members.

2. An electrical panel, according to Claim 1, characterized in that said central body is supported by a substantially rectangular plate-like base, rigid therewith by means of coupling means and having vertically upwardly 90° bent edges, with said central body there being removably associated a central terminal portion and front upright elements for supporting at least some of said electromechanical operating elements.

3. A withdrawing-drawer electrical panel, according to one or more of the preceding Claims, characterized in that to said central body there are removably associated a rear closure element, at least an outer upright, one or more door, omnibus bus-bars, electrical terminal portions and raising tools.

4. A withdrawing-drawer electrical panel, according to one or more of the preceding Claims, characterized in that said electrical panel comprises at least a withdrawing drawer, adapted to be removably associated with the fixed guides of said central body, said drawer representing a base module which has been specifically designed for application with fuse protection or with automatic breaker protection.

5. A withdrawing-drawer electrical panel, according to Claim 4, characterized in that to said base modular drawer there are associated supporting elements for supporting electromechanical appliances and a so-called book system adapted to perform the wiring operations by using precut and preterminated wires.

6. A withdrawing-drawer electrical panel, according to one or more of the preceding Claims, characterized in that to said base modular drawer and the drawers derived therefrom, there is coupled an interexchangeability block element, consisting of at least a pin rigid with the rear panel of the drawer and adapted to be engaged in a seat defined in a predetermined portion of said central body.

7. A withdrawing-drawer electrical panel, according to one or more of the preceding Claims, characterized in the the omnibus bus-bar system has been specifically designed so as to afford the possibility of making, by using a single type of bus-bars, at least three types of omnibus conductor bars.

8. A withdrawing-drawer electrical panel, according to one or more of the preceding Claims, characterized in that said central body is free at each side thereof, in order to afford the possibility of using coupling applicances such as riveting devices and pneumatic screwing devices.

9. A withdrawing-drawer electrical panel, of the modular and composable type, for controlling electrical motors, according to one or more of the preceding Claims, and substantially as broadly disclosed and illustrated for the intended task and objects.

Fig. 1

Fig.2

Fig.3

Fig.4

23

CE

Fig.5

EP 0 311 574 A2

Fig.6